# EUROPÄISCHE PATENTSCHRIFT

(11) **EP 1 902 464 B1**
(45) Veröffentlichungstag und Bekanntmachung des Hinweises auf die Patenterteilung: **12.06.2019**
(21) Anmeldenummer: 06752907.3
(22) Anmeldetag: 06.07.2006
(51) Int. Cl.: H01L 21/67, H01L 21/673, H01L 21/677

(54) **VORRICHTUNG ZUR LAGERUNG VON SUBSTRATEN**
DEVICE FOR STORING SUBSTRATES
DISPOSITIF POUR STOCKER DES SUPPORTS

(30) Priorität: 09.07.2005 CH 11502005
(43) Veröffentlichungstag der Anmeldung: 26.03.2008
(73) Patentinhaber: Murata Machinery, Ltd., Minami-ku Kyoto-shi Kyoto 601-8326 (JP)
(72) Erfinder: JAEGER, Erich, CH-8500 Frauenfeld (CH); BALG, Christian, CH-8274 Tägerwilen (CH)
(74) Vertreter: Weickmann & Weickmann PartmbB
(86) Internationale Anmeldenummer: PCT/CH2006/000356
(87) Internationale Veröffentlichungsnummer: WO 2007/006166

(56) Entgegenhaltungen:
- EP-A- 1 414 060
- WO-A-97/38439
- WO-A-2005/006407
- DE-A1- 19 535 871
- US-A1- 2004 182 472
- US-B1- 6 647 616
- PATENT ABSTRACTS OF JAPAN Bd. 1997, Nr. 07, 31. Juli 1997 (1997-07-31) -& JP 09 086666 A (ROHM CO LTD), 31. März 1997 (1997-03-31)
- RITZMANN, HEINZ: "Single Wafer Management Systems and Bare Wafer Storage as Key to Increased Yield and Productivity" 2005 IEEE/SEMI ADVANCED SEMICONDUCTOR MANUFACTURING CONFERENCE AND WORKSHOP PROCEEDINGS, 11. April 2005 (2005-04-11), Seiten 91-95, XP002371536 Piscataway, NJ, USA (IEEE Cat. No. 05CH37654). ISBN: 0-7803-8996-4

## Beschreibung

Die Erfindung betrifft eine Vorrichtung zur Lagerung von Substraten, wie sie im Oberbegriff des Patentanspruchs 1 wiedergegeben ist. Zudem betrifft die Erfindung ein Verfahren gemäss dem Oberbegriff von Anspruch 22. Elektronische Bauteile werden üblicherweise aus einem plattenförmigen Substrat erzeugt, das in der Regel als etwa kreisförmige Halbleiterscheibe (Wafer) ausgebildet ist. Diese Substrate müssen verschiedenen Prozeßanlagen zugeführt werden, in denen die Substrate im wesentlichen oberflächenbehandelt werden. Vor allem in diesem Zusammenhang ist es oftmals erforderlich, die Substrate zwischen zu lagern, wenn beispielsweise nach Abschluß einer Prozessierung in einer Prozeßanlage die Substrate nicht unmittelbar folgend einer anderen Prozeßanlage zugeführt werden können. Es ist üblich, die Substrate dann in einer Speichervorrichtung unter Rein- bzw. Reinstraumbedingungen zwischen zu lagern. Da die Kosten zur Erzeugung von Reinraumbedingungen im wesentlichen von der Größe des Raumes abhängig ist, wird in der Regel angestrebt, die Substrate mit möglichst geringem Abstand zueinander zu lagern.

Trotz des möglichst geringen Abstands zueinander ist es oftmals erforderlich, nur bestimmte einzelne Wafer aus der Lagervorrichtung entnehmen zu können. Damit trotz sehr geringem Lagerungsabstand von aufeinander folgenden Wafern in einem Stapel von Wafern eine Entnahme von einzelnen vorbestimmten Wafern möglich ist, wurde bereits eine Lagerungsvorrichtung vorgeschlagen, wie sie in der WO 2005/006407 A1 beschrieben ist. Diese Lagerungsvorrichtung weist einzelne, aufeinander stapelbare Lagerungselemente auf, die mit gegenüber ihrem Stapelbereich erhöhten Auflagern versehen sind, auf denen jeweils ein Wafer angeordnet werden kann. Ein nachfolgendes Lagerungselement wird auf dem Stapelbereich des vorangehenden Lagerungselement angeordnet. Die Wafer kommen hierdurch mit ihren Oberflächen in einem Stapel solcher Lagerungselemente mit sehr geringem Abstand zueinander zu liegen. Um entweder einen Wafer von einem bestimmten Lagerungselement zu entnehmen oder auf dem Lagerungselement einen Wafer abzusetzen wird eine Relativbewegung zwischen dem Stapel und einem Öffnungsmittel durchgeführt, um das Öffnungsmittel an einer bestimmten Stelle des Stapels anzuordnen. Anschließend greift das Öffnungsmittel an einem oder mehreren Lagerungselementen an, um den Abstand zwischen zwei in Stapelrichtung unmittelbar aufeinander folgenden Lagerungselementen zu vergrössern. Dies ermöglicht dann den Zugriff auf den Bereich des Lagerungselements auf dem ein Wafer gelagert ist bzw. gelagert werden soll.

Um überhaupt einen Stapel bilden zu können, der trotz einer grossen Anzahl von Lagerungselementen nicht sofort kippt oder verrutscht, weisen die Lagerungselemente aus der WO 2005/006407 A1 als Stapelhilfe Zentrierdome auf. Die Zentrierdome übereinander angeordneter Lagerungselemente greifen hierbei ineinander und verleihen somit dem Stapel eine Stabilität. Es hat sich gezeigt, dass insbesondere bei einem grossen Stapel von Lagerungselementen diese Lösung trotz der Stapelhilfe hohe Anforderungen an die Fertigungsgenauigkeit der Lagerungselemente stellt. Insbesondere Fertigungsungenauigkeiten, die den Stapelbereich des jeweiligen Lagerungselements oder die Stapelhilfe selbst betreffen, können sich bei aufeinander folgenden Lagerungselementen zu einer erheblichen Verschiebung der Ist-Positionen gegenüber den Sollpositionen der Lagerungselemente im Stapel aufaddieren. Treten solche Fertigungsungenauigkeiten bei mehreren Lagerungselementen stets an der gleiche Stelle auf, so können diese zu einer erheblichen Instabilität des Speicherstapels und im schlimmsten Fall zu dessen Kippen führen.

Der Erfindung liegt deshalb die Aufgabe zugrunde einen Beitrag dazu zu liefern, dass auch dann auf Lagerungselemente in einem Stapel von relativ zueinander beweglichen, insbesondere voneinander separierbaren, Lagerungselementen zugegriffen werden kann, wenn diese mit Fertigungsungenauigkeiten behaftet sind oder aus einem sonstigen Grund ihre Ist-Positionen von ihren Soll-Positionen im Stapel der Lagerungselemente abweichen.

Diese Aufgabe wird bei einer Vorrichtung der eingangs genannten Art erfindungsgemäß durch eine Kompensationsmassnahme zum Ausgleich von Stapelfehlern gelöst. Die erfindungsgemässe Kompensation kann insbesondere zu einer mögichst exakten Positionierung eines Öffnungs- oder Zugriffsmittels relativ zu dem Lagerungselement im Stapel genutzt werden, auf das zur Ablage oder zur Entnahme zugegriffen werden soll. Die Kompensationsmassnahme kann insbesondere zur Korrektur von fertigungsfehlerbedingten Stapelfehlern führen, durch die sich eine Abweichung des Stapels von der vorgesehenen Stapelachse ergibt. Vorzugsweise werden mit den Kompensationsmassnahmen aber Fehler kompensiert, die zu einer Abweichung der Ist-Position eines bestimmten Lagerungselements im Stapel von seiner Soll-Position in Stapelrichtung, d.h. entlang der Soll-Stapelachse, führt. Besonders bevorzugt sind Kompensationsmassnahmen, mit denen sich beide Stapelfehlertypen ausgleichen lassen.

Ein solches erfindungsgemässes Kompensationsmittel kann beispielsweise in Stapelrichtung und in Bezug auf ihre Umfangsrichtung zueinander rotationsversetzt angeordnete Lagerungselemente beinhalten. Es hat sich gezeigt, dass Fertigungsungenauigkeiten oftmals auf systematischen Fehlern in der Produktion beruhen, beispielsweise wegen einer Ungenauigkeit einer zur Fertigung von zumindest in ihrem Stapelbereich im wesentlichen stets gleichen Lagerungsefementen verwendeten Spritzgussform. Systematische Fertigungsungenauigkeiten können aber auch aus anderen Gründen auftreten, beispielsweise wegen Prozessfehlern, insbesondere wegen ungeeigneten Prozessparametern.

Im Rahmen der Erfindung wurde erkannt, dass sich diese Fehler dadurch kompensieren lassen, dass man die voneinander separierbaren Lagerungselemente zueinander rotatorisch versetzt anordnet, wodurch sich die Fertigungsungenauigkeit über den Umfang des Stapels vorzugsweise gleichmässig verteilen lässt. Dies gilt insbesondere bei Verwendung von zumindest im wesentlichen gleichen Lagerungselemente zur Bildung von zumindest einem Teil eines Stapels. Werden ausgehend von einem ersten Lagerungselement mehrere Lagerungselemente zueinander versetzt angeordnet, so kann in Bezug auf eine Tendenz zur Neigung der gestapelten Lagerungselemente bei jenem Lagerungselement die Fertigungsungenauigkeit kompensiert sein, das wieder die gleiche Rotationsposition aufweist wie das genannte erste Lagerungselement. Die weiteren Lagerungselemente des jeweiligen Stapels können vorzugsweise nach dem gleichen Prinzip angeordnet sein. Da die Lagerungselemente somit deutlich näher an ihrer Soll-Position angeordnet sind, kann mit der erfindungsgemässen Massnahme die Positioniergenauigkeit von Öffnungsmitteln am Stapel verbessert werden, mit denen der Stapel für einen Zugriff auf Substrate geöffnet wird. Zudem kann mit der Erfindung die sonst bei solchen Speichertürmen zu befürchtende Kippneigung deutlich verringert werden.

Die erfindungsgemässe Kompensation lässt sich bereits durch einen Versatz aufeinanderfolgender Lagerungselemente von jeweils 180° erzielen. Auch mit anderen, stets gleich grossen, Rotationsversätzen der Lagerungselemente, beispielsweise jeweils 90° lassen sich stabile Stapel mit kompensierten Fertigungsfehlern erzielen.

Selbstverständlich sind auch innerhalb von 360° ungleiche Rotationsversätze möglich. Ebenso können auch Fertigungsungenauigkeiten erst nach mehr als 360° Rotationsversatz ausgeglichen sein. So können beispielsweise sechs aufeinander folgende Lagerungselemente um 180° - 90° - 180 - 90° - 180° zueinander versetzt sein. Ebenso ist es denkbar, sieben aufeinander folgende Lagerungselemente um die Winkel 120° - 90° - 180° - 120° - 90° - 120° zueinander versetzt anzuordnen. Weitere Lagerungselemente können vorzugsweise nach dem jeweils gleichen Muster angeordnet werden, wobei diese Angaben nur als Beispiele für eine Vielzahl von Möglichkeiten zu verstehen sind.

Um eine sichere Anordnung der Lagerungselemente im Stapel zu erreichen, können die Lagerungselemente mit Stapelhilfen versehen sein. Eine solche Stapelhilfe kann beispielsweise ein an einem Lagerungselement angeordnetes Formschlusselement sein, das in ein zum Formschlusselement komplementäres Element an einem nachfolgenden Lagerungsring eingreift. Als Formschlusselement kann beispielsweise ein Zapfen oder Dom vorgesehen sein, der in einen in Form und Grösse angepassten Hohlraum bzw. in eine Ausnehmung eingreift. Die Anordnung bzw. Positionen der Stapelhilfen am Lagerungselement sind mit Vorteil an den vorgesehenen Versatz der Lagerungselemente um die Stapelachse angepasst. Mit den erfindungsgemäss vorgesehenen Kompensationsmitteln können auch Fertigungsungenauigkeiten im Bereich der Stapelhilfen so ausgeglichen werden, dass weder eine Kippneigung entsteht als auch ein Zugriff auf bestimmte Lagerungselemente im Stapel sicher erfolgen kann.

Gemäss einem weiterem Aspekt der Erfindung, der auch selbstständige Bedeutung hat, kann die Vorrichtung auch zumindest ein Öffnungsmittel aufweisen, mit dem ein Abstand zwischen zwei in einem Stapel von Lagerungselementen angeordnete Lagerungselemente veränderbar, insbesondere vergrösserbar, ist, wobei die Vorrichtung zudem mit einem Detektionsmittel versehen sein kann, mit dem Informationen über Positionen von einzelnen Lagerungselementen im Stapel ermittelbar sind, die Vorrichtung ferner mit einer Steuerung versehen ist, der die Positionsinformationen zuführbar sind, wobei mit der Steuerung unter Berücksichtigung der Positionsinformationen Steuerungssignale erzeugbar sind, mit der das Öffnungsmittel und der Stapel relativ zueinander verfahrbar und relativ zueinander in einer Sollposition positionierbar sind.

Diese Lösung kann alternativ oder ergänzend zur Massnahme gemäss dem Kennzeichen von Patentanspruch 1 vorgesehen sein. Sie ermöglicht insbesondere durch eine Detektion der tatsächlichen Position von Lagerungselementen im Stapel auch bei Abweichungen von einer Sollposition eine situationsgerechte Positionierung des Öffnungsmittels in Bezug auf die Stapelrichtung erzielen zu können. Das Öffnungsmittel kann hiermit an der jeweils zum Zugriff auf ein bestimmtes Lagerungselement erforderlichen Position relativ zum Stapel positioniert werden. Aufgrund von Fertigungsungenauigkeiten oder aus sonstigen Gründen entstehende Positionsfehler von Lagerungselemente können hiermit sicher kompensiert werden.

In einer weiteren bevorzugten Ausgestaltung der Erfindung kann das Öffnungsmittel zumindest zwei Öffnungselemente aufweisen, die in Bezug auf eine Umfangsrichtung des Stapels zueinander versetzt angeordnet sind, vorzugsweise sich in Bezug auf den Stapel zumindest näherungsweise diametral gegenüber liegen. Mit der Erfindung ist es nun möglich, die Öffnungselemente unabhängig voneinander in eine zur Öffnung des Stapels günstigen relativen Position zu bringen, um auf ein vorbestimmtes Lagerungselement zuzugreifen. Hierzu kann jedes der Öffnungselemente unter Einbezug von Steuerungssignalen verfahrbar sein, die auf Detektionssignalen des dem jeweiligen Öffnungselement zugeordneten Detektionsmittel basieren. In einer bevorzugten Ausführungsform kann somit zunächst eine Grobpositionierung der Öffnungselemente stattfinden, bei der eine gemeinsame relative Verfahrbewegung der Öffnungselemente gegenüber dem Stapel erfolgt. Eine Feinpositionierung der Öffnungselemente kann dann durch die voneinander unabhängige relative Verfahrbarkeit der Öffnungselemente erzielt werden.

In einer bevorzugten Ausführungsform kann der Stapel in Richtung der Stapelachse verfahrbar sein. Diese Bewegungsmöglichkeit kann vorzugsweise zur Grobpositionierung der Lagerungselemente gegenüber den vorzugsweise zwei Öffnungsmitteln genutzt werden.

Des weiteren kann vorgesehen sein, dass mindestens ein Öffnungsmittel ebenfalls verfahrbar ist, vorzugsweise ebenfalls in Richtung der Stapelachse. Die Verfahrbarkeit der Öffnungsmittel kann zur Genaupositionierung der Öffnungsmittel gegenüber dem Lagerungselement genutzt werden, auf das zugegriffen werden soll.

Die Aufgabe wird zudem durch ein Verfahren gemäß den Ansprüchen 22 oder 23 gelöst.

Ein weiterer Aspekt der Erfindung beschäftigt sich damit, wie die in einem Stapel aus voneinander separierbaren. Lagerungselementen angeordneten Lagerungsobjekte vor einer Kontamination, insbesondere mit Schmutzpartikel, geschützt werden können. Um dies zu erreichen, können Mittel zur Einleitung eines Mediums in den Stapel sowie Gasleitmittel vorhanden sein.

In einer bevorzugten Ausführungsfom kann das Gasleitmitteil einen im Stapel ausgebildeten Kanal enthhalten, durch den das Medium gezielt strömt, in einen Bereich leitbar ist, der zur Auflage von Substraten vorgesehen ist. Damit können auf besonders vorteilhafte Weise im Inneren des Stapels Reinraumbedingungen geschaffen werden. In diesem Zusammenhang kann eine Ausgestaltung der Lagerungselemente vorgesehen sein, bei der die Lagerungselemente in Bezug auf eine Richtung von aussen auf einen Mittenbereich der Wafer zunächst zumindest eine Dichtung für ein gasförmiges Medium aufweist. In einem im Vergleich hierzu geringeren Abstand zum Mittenbereich sollte zumindest ein Gasleitelement vorgesehen sein, mit dem ein zugeführtes gasförmiges Medium innerhalb eines von mehreren Lagerungselementen gebildeten Stapels in einer zumindest näherungsweise vorbestimmten Weise geleitet werden kann. Das zumindest eine Gasleitelement sollte also dazu vorgesehen sein, eine Strömungsrichtung des Mediums in zumindest einem Teil des Stapels vorzubestimmen. In einer bevorzugten Weiterbildung kann ein erfindungsgemässes Lagerungselement zumindest eine Zentrier- und/oder Stapelhilfe aufweisen, die einen grösseren Abstand zum Mittenbereich des Lagerungselements bzw. zur Stapelachse aufweist als das Gasleitelement und vorzugsweise auch als die Dichtung.

Diese Lösung ermöglicht trotz der sehr beengten Platzverhältnisse in einem derartigen Stapel mehrere Funktionen zu realisieren. So können die Lagerungselemente sicher gestapelt werden, ohne dass die hierfür vorgesehenen Stapelhilfen einen in vorbestimmter Weise über die Wafer gerichteten Gasstrom entscheidend behindern können. Zudem kann alleine mit den Lagerungselementen der Gasstrom durch den Stapel geleitet werden, zusätzliche Gasleitelemente werden hierfür nicht zwingend benötigt. Mit dem gasförmigen Medium können Partikel aus dem Stapel herausgeführt werden, die sich auf der Oberfläche der gelagerten Wafer absetzen und dadurch zu Ausschuss bei der Herstellung von elektronischen Bauteilen führen könnten.

In einer bevorzugten Weiterbildung können als Gasleitelemente Ausnehmungen in den Lagerungselementen vorgesehen sein, wobei durch Ausnehmungen von mehreren Lagerungselemente eine kanalartige Anordnung gebildet wird. Diese kanalartige Anordnung kann dazu genutzt werden, um das an einer oder mehreren Stellen in den Stapel eingeführte gasförmige Medium durch den Stapel hindurchzuleiten und an geeigneten Stellen in Richtung auf die Waferoberflächen austreten zu lassen.

Die Dichtung kann vorzugsweise durch die Ausbildung von zumindest einer Dichtlippe an der Unter- und/oder Oberseite jedes Lagerungsring realisiert sein. Die Dichtlippen können sich hierbei im Bereich der Gasleitelemente entlang zumindest eines Umfangsabschnitts der Lagerunsringe erstrecken, um an dieser Stelle einen Austritt des gasförmigen Mediums aus dem Stapel heraus zu verhindern. Die Dichtwirkung kann insbesondere dadurch erzielt werden, dass die entsprechende Dichtlippe gegen einen benachbarten Lagerungsring anliegt wodurch sich jeweils zwischen zwei Lagerungselementen eine Sperre für den Gasfluss ergibt. In einer bevorzugten Ausgestaltung der Erfindung können zwischen zwei Lagerungselementen mehrere Dichtlippen vorhanden sein, die zusammen eine Dichtung in Form einer Labyrinthdichtung ergeben.

Weitere bevorzugte Ausgestaltungen der Erfindung ergeben sich aus den Ansprüchen, der Beschreibung und der Zeichnung. Hierbei wird die Erfindung durch die Ansprüche definiert.

Die Erfindung wird anhand von in den Figuren rein schematisch dargestellten Ausführungsbeispielen näher erläutert, es zeigen:
- Fig. 1: eine Vorrichtung zur Lagerung von Wafern mit einem Stapel aus Lagerungsringen in einer perspektivischen Darstellung;
- Fig. 2: ein Ausschnitt aus Fig. 1, bei dem nur ein Teil des Stapels dargestellt ist;
- Fig. 3: eine Draufsicht auf die Vorrichtung gemäss der Darstellung von Fig. 1 und Fig. 2;
- Fig. 4: eine perspektivische Teildarstellung von mehreren aufeinander gestapelten Lagerungselementen, die gemäss einer weiteren Ausführungsform der Erfindung ausgestaltet sind;
- Fig. 5: einen Ausschnitt aus Fig. 4;
- Fig. 6: eine Teildarstellung eines Lagerungsrings aus Fig. 4 und 5;
- Fig.7: eine Draufsicht auf eine des Lagerungsring aus Fig. 6;
- Fig. 8a: eine perspektivische Schnittdarstellung von einem Stapel von Lagerungsringen gemäss den Fig. 4 bis 7;
- Fig. 8b: eine weitere perspektivische Schnittdarstellung von einem Stapel von Lagerungsringen gemäss den Fig. 4 bis 7;
- Fig. 9: eine schematisierte Teilschnittdarstellung durch einen Stapel von Lagerungsringen;
- Fig. 10: eine perspektivische Darstellung einer Öffnungseinrichtung;
- Fig. 11a-c: eine Darstellung von Verfahrensschritten zur Öffnung *eines* mit den Lagerungsringen aus den Fig. 4 bis 10 gebildeten Stapels mit eine Öffnungseinrichtung aus Fig. 10;
- Fig. 12a-c: eine weitere Darstellung von Verfahrensschritten zur Öffnung eines mit den Lagerungsringen aus den Fig. 4 bis 10 gebildeten Stapels.

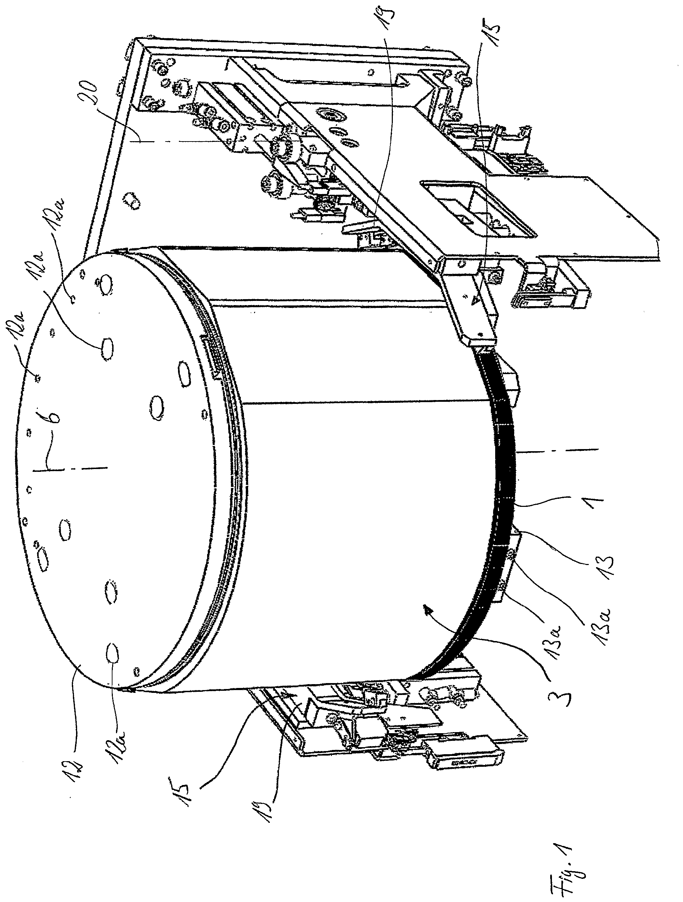

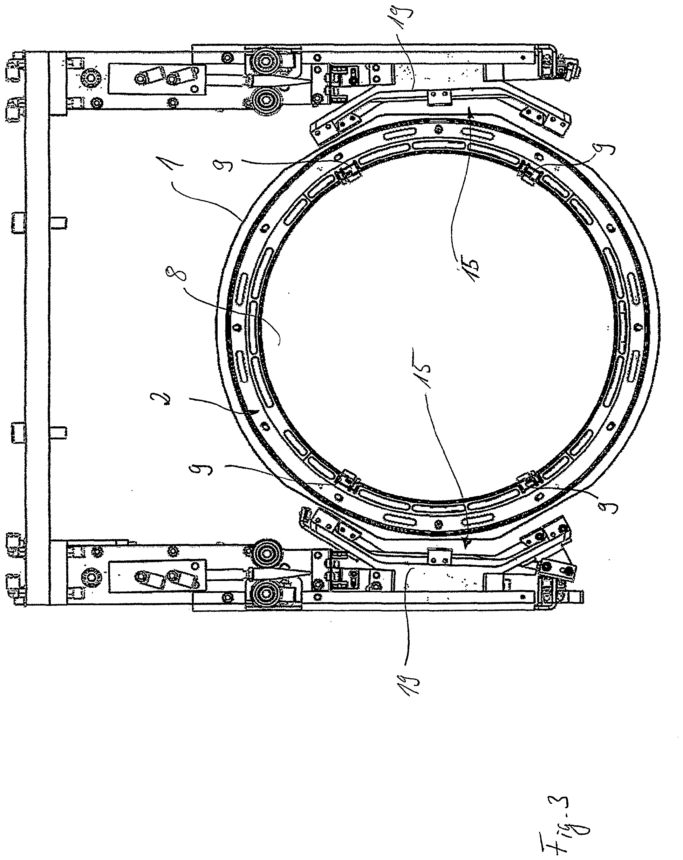

Die Erfindung geht von Lagerungselementen und deren Handhabung aus, wie sie prinzipiell bereits in der WO 2005/006407 beschrieben sind. Die u.a. in Fig. 3 gezeigten Lagerungselemente sind als Lagerungsringe 1 ausgebildet und weisen einen Stapelbereich 2 auf, mit dem sie zur Lagerung in einem Stapel von Lagerungselementen angeordnet werden können. Ein solcher Stapel 3 ist auch in Fig. 1 gezeigt, wobei hier nur die unteren Lagerungsringe 1 des Stapels 3 dargestellt sind. Die weiteren Lagerungsringe sind lediglich in Form der Kontur des sich durch die Lagerungsringe ergebenden Stapels gezeigt.

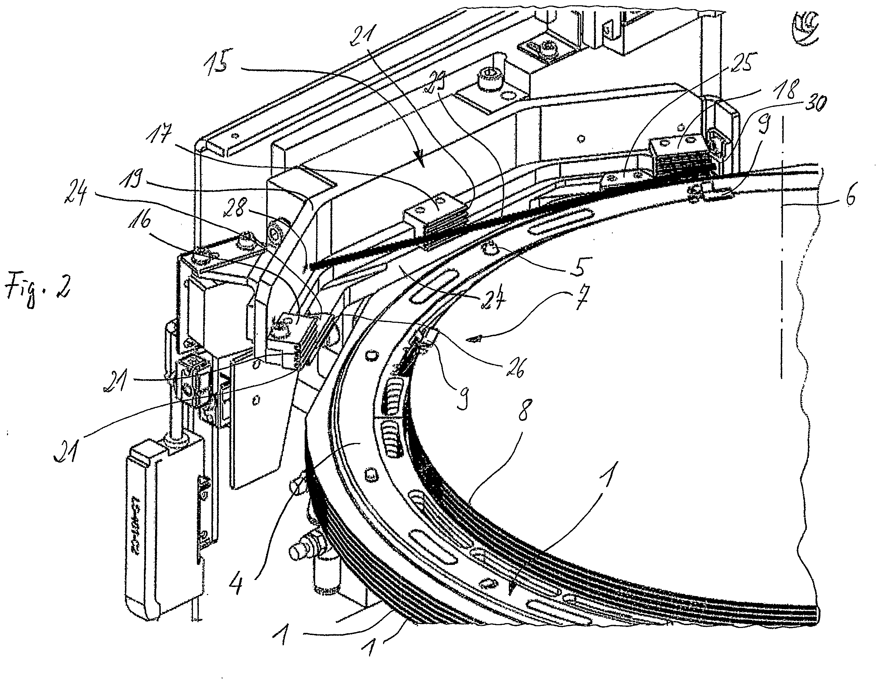

Wie u.a. in Fig. 2 gezeigt ist, ist im hier dargestellten Ausführungsbeispiel der Lagerungselemente als Stapelbereich 2 ein Ringteil 4 der Lagerungselemente vorgesehen, mit dem die Lagerungselemente aufeinander auf liegen. Bis auf den obersten und den untersten Lagerungsring des Stapels aus Fig. 1 liegt somit jeder Lagerungsring auf dem im Stapel jeweils unter ihm angeordneten Lagerungsring 1 auf. Ebenso ist auf seinem Stapelbereich der im Stapel jeweils über ihm folgende Lagerungsring angeordnet. Der Kontakt mit den benachbarten Lagerungsringen erfolgt stets mit dem Ringteil 4 der Lagerungsringe 1.

Jeder Lagerungsring weist an seinem Ringteil 4 als Stapelhilfe zumindest zwei domartige, vom Ringteil 4 abstehende, Zentrierelemente 5 auf, mit denen eine exakte Stapelung der Lagerungsringe 1 entlang einer Stapelachse 6 erreichbar ist. Die beiden Zentrierelemente von jedem Lagerungsring sind jeweils um 180° zueinander versetzt. Zudem sind die Zentrierelemente 5 aufeinander folgender Lagerungsringe ineinander stapelbar, wodurch die Lagerungsringe mit geringem Abstand, aber trotzdem exakt zur Stapelachse 6 ausgerichtet (zentriert) aufeinander stapelbar sind. Im Stapelzustand liegen die Lagerungsringe somit näherungsweise aufeinander auf, wodurch ein Zugriff auf einen Lagerbereich 7 der Lagerungselemente, zur Entnahme oder zur Einfügung eines Wafers 8 nicht ohne weiteres möglich ist.

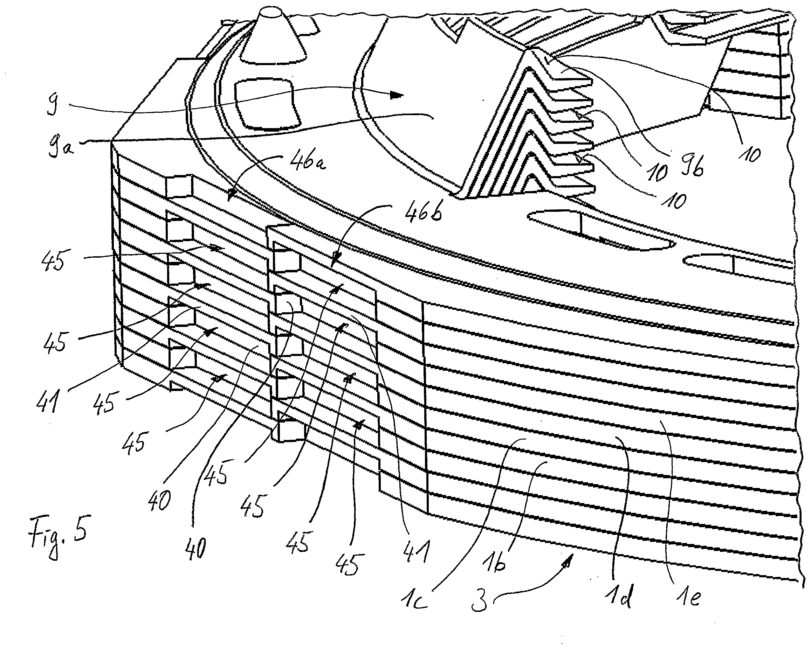

Jeder der bezüglich ihres konstruktiven Aufbaus identischen Lagerungsringe weist zudem im Lagerbereich 7 vier Halterungselemente 9 auf, die zur Aufnahme von jeweils einem Wafer 8 pro Lagerungsring vorgesehen sind. Ausgehend vom Ringteil 4 weisen die Halterungselemente 9 einen schräg nach oben und auf die Mitte des Ringteils verlaufenden ersten Abschnitt 9a auf, an den sich ein zweiter Abschnitt 9b anschliesst, der eine im wesentlichen ebene und leicht nach unten geneigte Auflagefläche 10 aufweist (z.B. Fig. 5). Die Wafer 8 sind zur Anordnung auf den Auflageflächen 10 der Halterungselemente 9 vorgesehen.

Durch fertigungstechnische Ungenauigkeiten, beispielsweise einer Spritzgussform, unter deren Verwendung die Lagerungsringe 1 in der Regel hergestellt werden, können sämtliche Lagerungselemente an stets der gleichen Stelle beispielsweise eine erhöhte Dicke des Ringteils aufweisen. Ein anderer möglicher wiederholgenauer Fehler kann auch eine Abweichung von der Soll-Planheit (Unebenheiten) und ähnliches sein. Zur Kompensation solcher stets an der gleichen Stelle der Lagerungselemente auftretender Fehler können im Stapel aufeinander folgende Lagerungselemente um einen bestimmten Drehwinkel zueinander versetzt angeordnet sein.

Im Ausführungsbeispiel von Fig. 1 - 4 beträgt der Drehwinkel 180° um die lineare Stapelachse 6, entlang der die Lagerungselemente aufeinander gestapelt sind. Damit sind auch die Stellen mit einer bestimmten Fertigungsungenauigkeit von aufeinander folgenden Lagerungselementen um 180° versetzt. Ohne diesen Versatz würden die Fertigungsungenauigkeiten der Lagerungselemente sich stets an der gleichen Winkelposition des Stapels einseitig aufsummieren. Dies könnte zu einer erheblichen Schieflage des Turms bzw. Stapels 3 führen. Durch die erfindungsgemässe Massnahme werden die Ungenauigkeiten gleichmäßig auf sich diametrial gegenüberliegende Seiten des Stapels 3 verteilt und damit eine einseitige Neigung des Stapels verhindert. Dies gilt selbst dann, wenn die Lagerungselemente mehrere systematisch auftretende Fertigungsungenauigkeiten aufweisen sollten.

In der Darstellung von Fig. 1 ist auf den Stapel 3 von Lagerungsringen eine Deckplatte 12 aufgelegt. Der Stapel 3 befindet sich zusammen mit der Deckplatte auf einer Bodenplatte 13, die mit Anschlüsse13a für Luft, Stickstoff oder einem sonstigen Gas versehen ist. Mittels dieser Anschlüsse ist über die Bodenplatte 13 eine GasVersorgung anschließbar, um im Stapel 3 eine näherungsweise geschlossene Atmosphäre zu erzeugen.

Die Bodenplatte 13 ist in einer nicht näher dargestellten Weise mit einer linear verfahrbaren Z-Achse verbunden, wodurch der Stapel 3 in vertikaler Richtung entlang der Stapelachse 6 angehoben und abgesenkt werden kann. Die Z-Achse weist einen Servo-Antrieb der Fa. Lust Antriebstechnik GmbH sowie eine lineare Bewegungsachse der Fa. HSB Antriebstechnik GmbH, Reutlingen, auf. Die lineare Bewegungsachse weist zudem eine vom Servo-Antrieb angetriebene Kugelumlaufspindel auf, die mit einem Schlitten verbunden ist, der wiederum auf einer parallel zur Z-Achse ausgerichteten Profilschiene angeordnet ist. Eine übergeordnete SPS-Steuerung der Fa. Eckelmann AG steuert die Bewegungen der Z-Achse sowie die Bewegungen von weiteren Achsen der Vorrichtung.

Die Vorrichtung ist ferner mit einem Öffnungsmittel versehen, mit dem der Abstand von jeweils einem vorbestimmbaren Lagerungsring 1 zu benachbarten Lagerungsringen 1 vergrössert werden kann, um einen Zugriff auf den jeweiligen Lagerungsring 1 zu ermöglichen. Wie insbesondere aus Fig. 3 ersichtlich ist, weist das Öffnungsmittel hierzu zwei sich in Bezug auf den Stapel diametral gegenüberliegende Öffnungseinrichtungen 15 auf. Aus der Darstellung von einem der Öffnungseinrichtungen 15 in Fig. 2 kann entnommen werden, dass jede der Öffnungseinrichtungen jeweils mit drei mit Abstand zueinander angeordneten Halteelementen 16, 17, 18 versehen ist. Die Halteelemente 16-18 jeder Öffnungseinrichtung 15 sind an jeweils einem Träger 19 der jeweiligen Öffnungseinrichtung 15 starr angeordnet. Die beiden Träger 19 sind jeweils um ihre Schwenkachse 20 schwenkbar angeordnet, wobei beide Schwenkachsen 20 parallel zur Stapelachse 6 verlaufen. Die Halteelemente 16-18 befinden sich hierbei in Bezug auf die Stapelachse 6 auf der gleichen Höhe, sind identisch ausgebildet und weisen jeweils mehrere parallel zueinander verlaufende Nuten 21 auf, deren Breiten unwesentlich größer sind als die Höhe des Ringteils 4 der Lagerungsringe. Die Mittenabstände der Nuten 21 jedes Halteelements 16-18 entsprechen den Mittenabständen, die aufeinanderfolgende Lagerungsringe im Stapel aufweisen.

Zwischen dem mittleren Halteelement 17 und den beiden äusseren Halteelementen 16, 18 ist jeweils unmittelbar neben den beiden äusseren Halteelementen 16, 18 ein Separierelement 24, 25 angeordent. Die Separierelemente 24, 25 weisen jeweils eine Nut 26 auf, die beide parallel zu den Nuten 21 der Halteelemente 16-18 verlaufen. Beide Separierelemente 24, 25 jeder Öffnungseinrichtung 15 sind an jeweils einem parallel zur Stapelachse 6 linear verfahrbaren Schlitten 27 angeordnet. Die beiden Schlitten 27 wiederum befinden sich auf jeweils einer (nicht näher dargestellten) Schiene, die an jeweils einem der beiden schwenkbaren Träger 19 befestigt ist. Die Separierelemente 24, 25 sind somit schwenkbar und gegenüber den Halteelementen 16-18 relativ verfahrbar.

An jedem der beiden Träger 19 der Halteelemente 16-18 ist zudem ein optischer Sensor angebracht, beispielsweise eine Lichtschranke mit einem Lichtsender 28 (Laser oder dergleichen), dessen Lichtstrahl auf einen Lichtempfänger 30 gerichtet ist. Wie insbesondere aus Fig. 2 hervorgeht ist der Lichtstrahl 29 hierbei so ausgerichtet, dass dieser durch den Umfangsbereich eines Lagerungsrings 1 unterbrochen wird, falls sich ein solcher Lagerungsring des Stapels 3 auf der Höhe des optischen Sensors befindet. Da die Lagerungsringe 1 im gestapelten Zustand zumindest in ihrem Umfangsbereich einen geringen Abstand zueinander aufweisen, wird der *Lichtstrahl 29 nicht unterbrochen, wenn sich dieser relativ zum* Stapel 3 zwischen zwei Lagerungsringen befindet.

In einem von mehreren möglichen Zugriffsverfahren auf einen Lagerungsring 1, die mit dieser Vorrichtung zur Anwendung kommen können, wird in einem ersten Schritt ein initialisierender Teachvorgang durchgeführt. Hierbei wird - ausgehend von einer Referenzposition der Bodenplatte 13 entlang der Stapelachse 6 - der gesamte Stapel 3 mittels einer vertikalen Verfahrbewegung der Bodenplatte 13 mit konstanter Geschwindigkeit an der Lichtschranke vorbeigeführt. Aufgrund der Funktion *Strecke = Geschwindigkeit * Zeit* legt die Steuerung bei jeder Unterbrechung der Lichtschranke einen Streckenwert sowie die Nummer des dazugehörenden Lagerungsrings in einer von der Steuerung angelegten Datentabelle ab. Dieser Streckenwert entspricht dem Abstand des jeweiligen Lagerungsrings 1 von der Bodenplatte 13.

Soll dann auf einen bestimmten Lagerungsring 1 zugegriffen werden, wird der zum entsprechenden Lagerungsring gehörende Streckenwert aus der Datentabelle ausgelesen. Die Steuerung veranlasst nachfolgend, dass die Bodenplatte 13 in Bezug auf die Referenzposition um die dem Streckenwert entsprechende Position verfahren wird. Sobald sich der für den Zugriff freizustellende Lagerungsring 1 in Bezug auf die Stapelachse 6 auf der gleichen Höhe wie die Separierelemente 24, 25 befinden, schwenken die Träger 19 synchron aber in gegenläufigen Schwenkbewegungen um ihre jeweilige Schwenkachse 20 auf den Stapel 3 zu. Hierdurch wird einerseits der freizustellende Lagerungsring in den Nuten 26 der Separierelemente 24, 25 aufgenommen. Andererseits werden die unmittelbar über diesem Lagerungsring angeordneten *vier* Lagerungsringe *in* den jeweils vier Nuten 21 jedes Halteelements 16-18 angeordnet.

Nun wird die Bodenplatte 13 um eine bestimmte Strecke abgesenkt. Die Separierelemente 24, 25 verfahren hierbei mit dem freizustellenden Lagerungsring ebenfalls nach unten, allerdings um eine kleinere Strecke als die Bodenplatte. Die Bewegung der Separierelemente 24, 25 kann hierbei alleine aufgrund ihrer Gewichtskraft und der Gewichtskraft der Schlitten 27 erfolgen. Ebenso ist es möglich diese Bewegung durch eine Nachführung mittels eines Pneumatikzylinders oder durch die Kraft einer Feder auszuführen bzw. zu unterstützen. Aufgrund dieser Bewegungen wird einerseits zwischen dem freizustellenden Lagerungsring 1 und dem diesem in Stapelrichtung nach oben nachfolgenden Lagerungsring ein Abstand vorbestimmter Größe geschaffen. Zudem wird auch zu dem nach unten im Stapel unmittelbar folgenden Lagerungsring der Abstand um einen vorbestimmten Wert vergrößert.

Hierdurch wird es möglich, mit einem Greifer (nicht näher dargestellt) zwischen den Wafer 8 des nun freigestellten Lagerungsringes 1 und des Wafers 8, der auf dem nach unten im Stapel nachfolgenden Lagerungsring 1 angeordnet ist zu fahren. Der gewünschte Wafer 8 kann dann in Richtung des nach oben nachfolgenden Lagerungsringes angehoben und entnommen werden. Auf die gleiche Weise, jedoch in umgekehrter Reihenfolge, kann auch ein Wafer auf einen so freigestellten Lagerungsring abgesetzt werden. Durch ein Anheben der Bodenplatte 13 um den zuvor für die Absenkeung nach unten zurückgelegten Weg, wird der Stapel wieder geschlossen. Die Träger 19 können dann wieder vom Stapel 3 weg geschwenkt werden, so dass letzterer insgesamt wieder in Richtung der Stapelachse 6 verfahrbar ist, bespielsweise in die Referenzposition.

Ein hierzu alternatives Verfahren kann vorsehen, für jeden Zugriff auf einen vorbestimmten Lagerungsring 1, mittels des Sensors die Position des jeweils freizustellenden Lagerungsringes im Stapel zu bestimmen, beispielsweise in Bezug auf die Bodenplatte 13. Aufgrund dieser Detektion kann der Stapel vor dem Öffnungsmittel positioniert werden. Der eigentliche Öffnungsvorgang des Stapels kann dann in der zuvor bereits beschriebenen Weise erfolgen. Um einen bestimmten Lagerungsring im Stapel zu ermitteln ist es lediglich erforderlich, dass die Steuerung die Anzahl von Unterbrechungen zählt, die der Position des entsprechenden Lagerungsrings im Stapel entspricht. Sofern der Sensor in Z-Richtung sich auf der gleichen Höhe wie die Separierelemente 24, 25 befinden, so sind zum Zeitpunkt der letzten Unterbrechung des Lichtstrahls 29 die Separierelemente 24, 25 bereits auf der gleichen Z-Position wie der freizustellende Lagerungsring. Andernfalls muss von der Steuerung der Abstand in Z-Richtung zwischen dem Sensor und den Separierelementen 24, 25 für eine entsprechende Nachführung der Separierelemente berücksichtigt werden.

Aufgrund des stets erforderlichen Detektionsvorgangs ist diese Ausführungsform des erfindungsgemäßen Verfahrens vermutlich geringfügig langsamer als die zuerst beschriebene Ausführungsform. Besonders vorteilhaft ist diese Ausführungsform jedoch wegen ihrer hohen Genauigkeit, da jeder Zugriff aufgrund von aktuellen, unmittelbar zuvor ermittelten, Detektionsergebnissen erfolgt.

Eine weitere erfindungsgemäße Ausführungsform, die in Kombination mit jeder der zuvor genannten Ausführungsform kombinierbar ist, kann vorsehen, dass an beiden Trägern 19 Detektionsmittel zur Bestimmung der Positionen der Lagerungsringe vorhanden sind bzw. beiden Trägern zugeordnet sind. Als Detektionsmittel können beispielsweise Sensoren verwendet werden, wie sie zuvor bereits beschrieben wurden. Mit dieser Lösung können die Zugriffspositionen für die Öffnungseinrichtungen 15 an beiden Seiten des Stapels erfasst werden. Die Positionsinformationen der Detektionsmittel beider Seiten können dann von der Steuerung dazu benutzt werden, die dem jeweiligen Detektionsmittel zugeordnete Öffnungseinrichtung 15 unabhängig von der anderen Öffnungseinrichtung zu positionieren. Die Öffnungseinrichtungen können hierzu durch eine Verfahrbewegung des Stapels 3 in vertikaler Richtung relativ zum Stapel vorpositioniert werden. Eine Genaupositionierung kann dann durch eine Verfahrbewegung der Separierelemente 24, 25 von einer oder beiden Seiten erfolgen, wobei die Separierelemente der beiden Öffnungseinrichtungen unabhängig voneinander bewegt werden können.

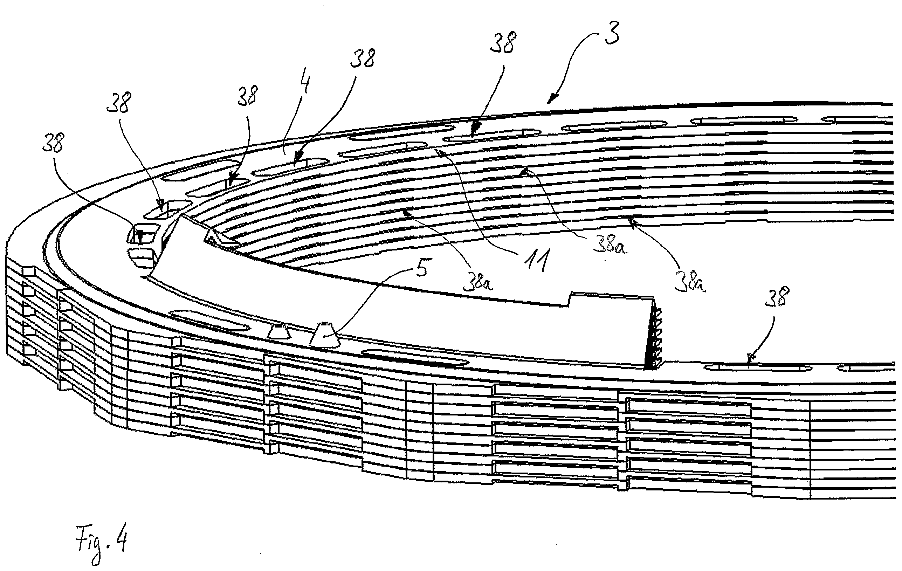

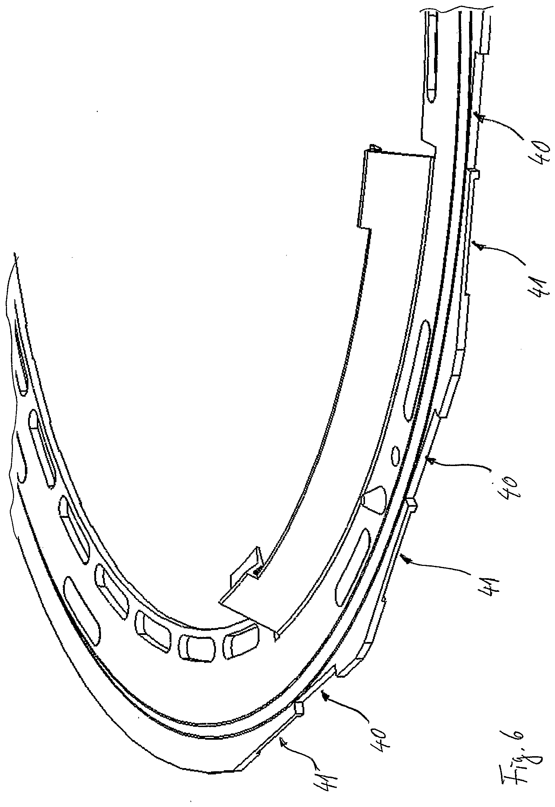

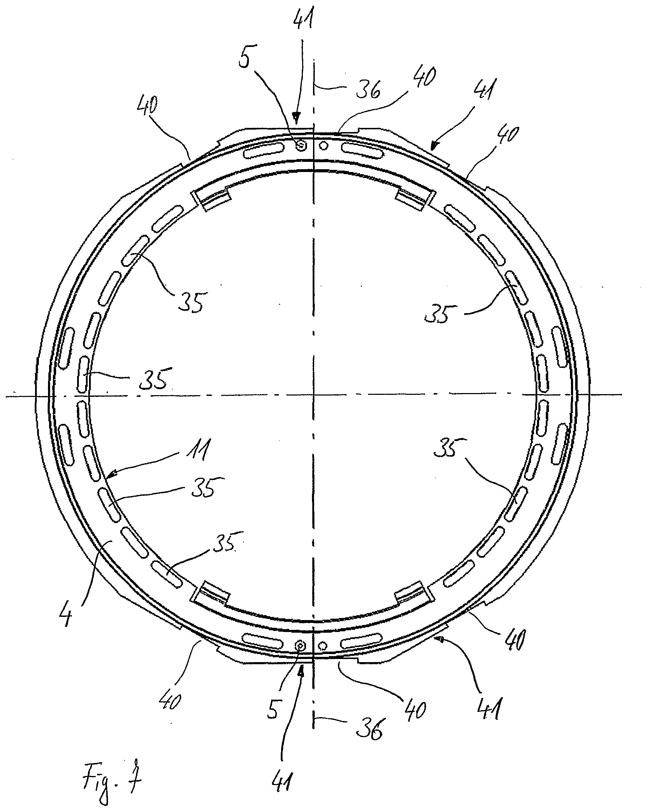

In den Fig. 4 bis 12 ist ein weiteres Ausführungsbeispiel gezeigt, bei dem in Bezug auf das Ausführungsbeispiel von Fig. 1 bis 3 prinzipiell gleiche Elemente mit identischen Bezugszeichen versehen sind. Auch hier sind wiederum aufeinander gestapelte, identische Lagerungsringe 1 vorgesehen, bei denen der Abstand aufeinanderfolgende Lagerungsringe veränderbar ist. Jeder der Lagerungsringe 1 weist im Bereich einer inneren Umfangsfläche 11 des Ringteils 4 mehrere langlochartige Ausnehmungen 35 auf. Hierbei sind die Ausnehmungen 35 eines Lagerungsrings spiegelsymetrisch bezüglich zumindest einer Durchmesserlinie 36 ausgebildet sind. Diese imaginäre Durchmesserlinien schneiden auch die Stapelachse, die wiederum als eine geradlinige Verbindung der Mittelpunkte der kreisrunden Waferoberflächen gesehen werden kann, sofern sich sämtliche Wafer eines Stapels in ihrer Soll-Positionen befinden.

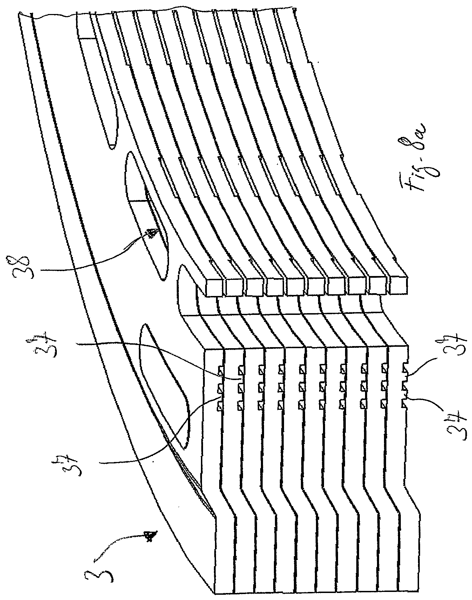

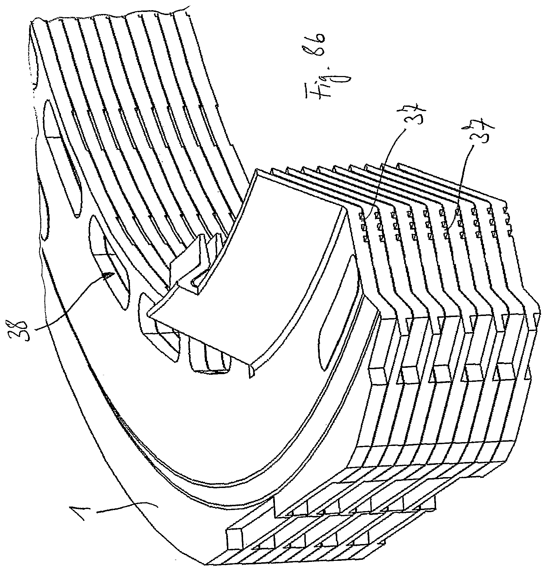

Wie insbesondere in Fig. 8a und 8b erkennbar ist, weisen die Lagerungsringe an ihrer Unterseite im Bereich der kanalartigen Ausnehmungen Stege 37 auf. Diese Stege 37 befinden sich in Bezug auf die Stapelachse mit geringerem Abstand zur Stapelachse als die Zentrierdome 5, sie weisen jedoch zur Stapelachse einen grösseren Abstand als die Ausnehmungen 35 auf. In anderen Ausführungsform können die Stege an der Oberseite der Lagerungsringe, bzw. bei jedem Lagerungsring sowohl an der Oberseite als auch an der Unterseite vorhanden sein.

In einem Stapel 3 aufeinander angeordnete Lagerungsringe 1 bilden hierdurch mit ihren kanalartigen Ausnehmungen 35 mehrere parallel zur Stapelachse und um die Wafer herum verlaufende Kanäle 38. Zudem liegen die Stege 37 gegen die Oberseite des jeweils nach unten nachfolgenden Lagerungsrings an Dadurch bilden zwei aufeinander gestapelte Lagerungsringe 1 jeweils eine um den gesamten Umfang verlaufende Dichtung, insbesondere eine Labyrinthdichtung. In anderen Ausführungsbeispielen, bei denen die Lagerungsringe sowohl an der Unter- als auch an der Oberseite mit Stegen versehen sind, kann zur Bildung einer Dichtung zwischen zwei Stegen 37 der Unterseite von einem Lagerungsring jeweils ein Steg 37 der Oberseite von einem unmittelbar darunter angeordneten Lagerungsring eingreifen.

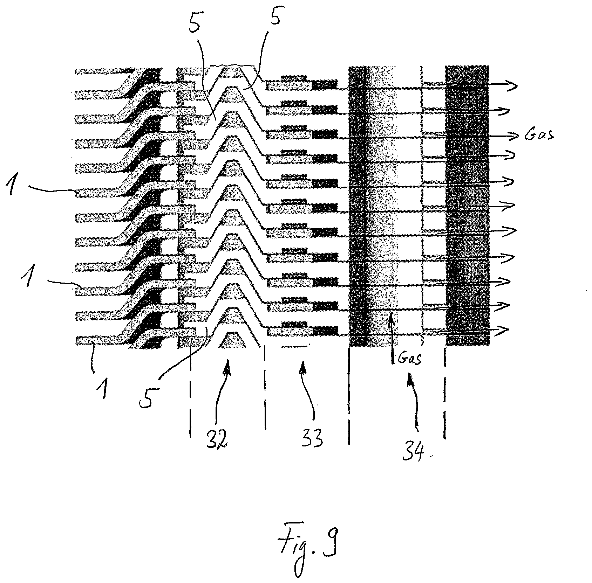

In Fig. 9 ist in einer Teildarstellung eines Schnitt durch einen Stapel gezeigt, dass sich somit im Stapel ein Bereich 32 der Zentrierelemente 5 aubildet. In Richtung auf die Stapelachse folgt dann ein daneben angeordneter Dichtungsbereich 33, an den sich in Richtung auf die Stapelachse schliesslich ein Kanalbereich 34 anschliesst.

Über einen an der Bodenplatte 13 (wie beispielsweise in Fig. 1 gezeigt) vorgesehenen Anschluss 13a, kann von unten in die Kanäle 38 ein gasförmiges Medium, wie beispielsweise Stickstoff zugeführt werden. Das Medium kann dann in den Kanälen 38 aufsteigen. Vorzugsweise wird das Medium nur in Kanälen einer Seite des Stapels zugeführt, beispielsweise über einen Umfangsabschnitt aus einem Bereich von ca. 70° bis 180°, vorzugsweise von 90° bis 120°. In anderen Ausführungsformen kann das Medium auch an einer anderen Stelle des Stapels zugeführt werden.

Aufgrund von Stellen mit einer verminderten Dicke der Begrenzungsabschnitte der Ausnehmungen 35 im Bereich der inneren Umfangsfläche werden dort Spalten 38a ausgebildet. Durch diese Spalte 38a strömt das unter Druck stehende Medium zwischen jeweils aufeinandertiegenden Lagerungsringen aus den Kanälen 38 hinaus. Da aufgrund der Zuführung des Mediums Druckunterschiede herrschen, fliesst das Medium über die Oberflächen der Wafer 8 von dieser Austrittsseite im Stapel über die Oberflächen der Wafer hinweg auf eine gegenüberliegende Abführseite. Das Medium kann dann an dieser Seite in die dortigen Kanäle 38 eintreten und über Ausnehmungen 12a in der Deckplatte 12 (s. Fig. 1) aus dem Stapel herausgelangen. Diese vorbestimmte Spülungsrichtung des Mediums innerhalb des Stapels 3 kann noch durch eine Absaugvorrichtung unterstützt werden. Diese kann sich insbesondere im Bereich der Deckplatte 12 auf der Abführseite des Stapels befinden, um das Medium hier aus dem Stapel herauszuführen.

Mit dem Medium können Partikel abgeführt werden, die sich im Stapel im Bereich der Wafer befinden. Das Medium ermöglicht somit innerhalb des Stapels Reinraum- bzw. Reinstraumbedingungen zu erzeugen.

Jeder Lagerungsring 1 weist zudem an seinem Umfang an sich diametral gegenüberliegenden Stellen jeweils drei Abschnitte mit einer nach unten und oben offenen Einkerbung 40 und drei Abschnitte mit einer nach unten offenen Abflachung 41 auf. Hierbei sind jeweils zwei unterschiedliche Abschnitte 40, 41 unmittelbar nebeneinander angeordnet. In Bezug auf eine Durchmesserlinie liegen hierbei bei einem Lagerungsring jeweils die beiden Abschnitte mit der Einkerbung 40 auf der gleichen Seite der jeweiligen Durchmesserlinie. Gleiches gilt für die Abschnitte mit der nach unten offenen Abflachung 41. Die Abschnitte 40, 41 sind dabei so angeordnet, dass bei einem rotativen Versatz aufeinanderfolgender Lagerungsring um jeweils 180° an beiden Seiten des Stapels und jeweils beidseits der Durchmesserlinie stets Abschnitte mit einer nach unten offenen Abflachung 41 unmittelbar über einem Abschnitt mit einer Einkerbung 40 zu liegen kommen und umgekehrt. Hierdurch bilden jeweils zwei übereinander angeordnete Lagerungsringe, beispielsweise Lagerungsringe 1c, 1d, auf beiden Seiten des Stapels 3 jedoch auf unterschiedlichen Seiten der Durchmesserlinie (bzw. aus Durchmesserlinien gebildeten Durchmesserebene) jeweils eine Eingriffstasche 45. In Bezug auf die jeweils gleiche Seite des Stapels 3 bildet zudem der untere Lagerungsring 1c dieser beiden Lagerungsringe mit dem nächst unteren Lagerungsring 1b und der obere 1c der beiden Lagerungsringe mit dem jeweils nächst oberen Lagerungsring 1e jeweils eine weitere Eingriffstasche 45, die sich jedoch auf der anderen Seite der Durchmesserlinie befindet. Hierdurch entstehen auf beiden Seiten des Stapels in vertikaler Richtung jeweils alternierend abwechselnd links und rechts der Durchmesserebene Reihen 46a, 46b mit Eingriffstaschen 45 (Fig. 5).

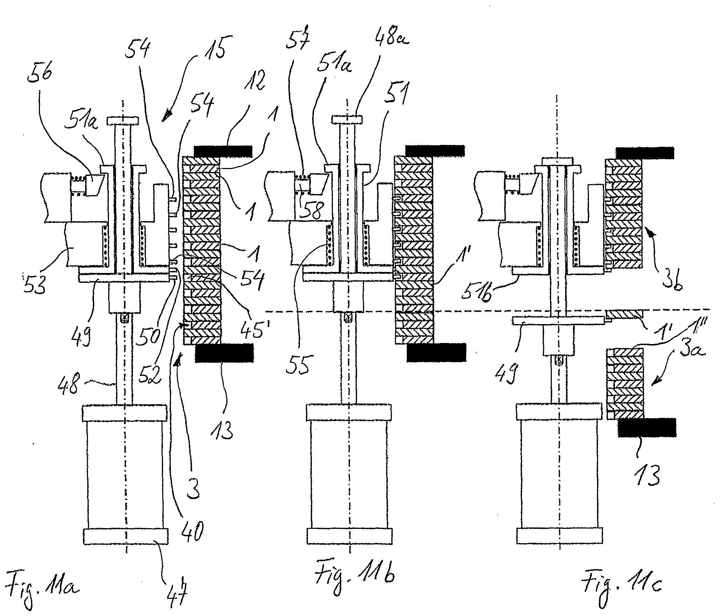

Auch dieses Ausführungsbeispiel weist auf beiden Seiten des Stapels im wesentlichen identische Öffnungsmittel auf, von denen in den Fig. 11a bis 11c nur die Öffnungseinrichtung 15 einer Seite dargestellt ist. Wie bei den bereits beschriebenen erfindungsgemässen Ausführungsformen sind auch bei dieser die Öffnungseinrichtungen 15 schwenkbar (nicht näher dargestellt) gelagert, so dass die Öffnungseinrichtungen seitlich auf den Stapel 3 zu und weg geschwenkt werden können.

Die Öffnungseinrichtungen sind jeweils mit einem Zylinder 47 versehen, der einen in vertikaler Richtung parallel zur Stapelachse ausfahrbare Kolbenstange 48 aufweist. An der Kolbenstange 48 ist ein unteres Eingriffsteil 49 befestigt, das mit einem zum Stapel weisenden Eingriffsfinger 50 versehen ist. Über dem unteren Eingriffsteil 49 ist auf der Kolbenstange 48 eine Hülse 51 aufgeschoben, die relativ zur Kolbenstange 48 in axialer Richtung beweglich ist. An ihren beiden axialen Enden ist die Hülse 51 jeweils mit einer scheibenförmige Stirnseite 51a, 51b versehen. An der unteren scheibenförmige Stirnseite 51b ist ein zum Stapel 3 hin weisender Eingriffsfinger ausgebildet.

Auf der Hülse 51 wiederum befindet sich zwischen deren beiden Stirnseiten 51a, 51b ein oberes Eingriffsteil 53, das insgesamt fünf übereinander angeordnete Eingriffsfinger 54 aufweist. Der Abstand aufeinander folgender Finger 54 entspricht hierbei dem Abstand, den aufeinander folgende Eingriffstaschen 45 (Fig. 5) der Lagerungsringe 1 zueinander aufweisen. Das gleiche gilt für den Abstand, den in der in Fig. 11a gezeigten Position der Eingriffsfinger 50 des unteren Eingriffsteils 49 vom untersten Eingriffsfinger 54 des oberen Eingriffsteils 53 aufweist. Das obere Eingriffsteil 53 ist gegenüber dem hier nicht näher dargestellten Träger des Öffnungsmittels fixiert.

Zwischen dem oberen Eingriffsteil 53 und der Hülse 51 befindet sich eine Druckfeder 55, welche das obere Eingriffsteil 53 mit einer Druckkraft in Richtung auf die obere scheibenförmige Stirnseite 48a der Hülse 51 bzw. die Hülse 51 in Richtung auf das untere Eingriffsteil 49 belastet. Das obere Eingriffsteil 53 ist zudem mit einem Verriegelungsmittel fest verbunden, dessen Klinke 56 auf einem quer zur Stapelachse 6 und gegen die Kraft einer Druckfeder 57 verfahrbaren Kolben 58 angeordnet ist. Sowohl das obere Eingriffsteil 53 als auch das Verriegelungsmittel sind gegenüber dem Träger 19 starr angeordnet. Die Klinke 56 kann unter die obere scheibenförmige Stirnseite 48a der Hülse 51 gefahren werden, wodurch die axiale Position der Hülse 51 fixiert ist.

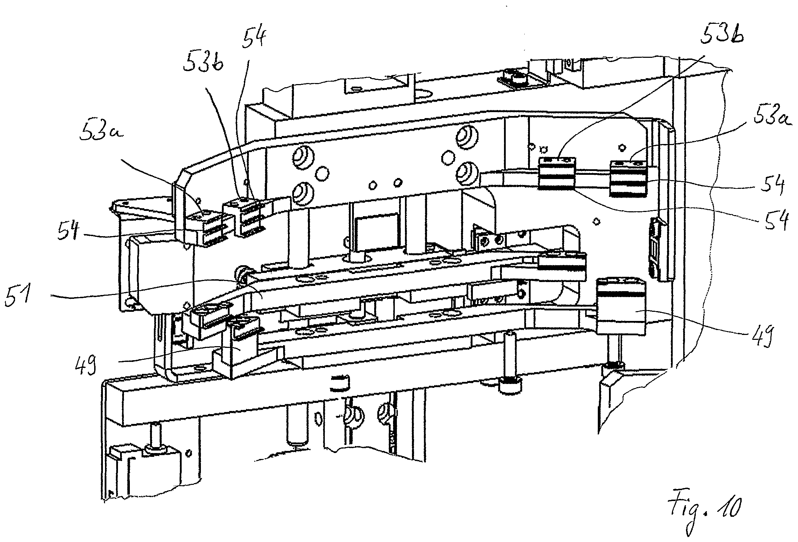

Wie dies in den prinzipiellen Darstellungen der Fig. 11a-c nicht zu erkennen, jedoch in Fig. 10 gezeigt ist, sind an jeder Öffnungseinrichtung die zuvor genannten Elemente unteres Eingriffsteil 49, Hülse 51 und oberes Eingriffsteil 53 zweimal vorhanden, wobei diese am Umfang des Stapels um ca. 30° zueinander versetzt sind. Die Finger 54 des oberen Eingriffsteils ergeben sich hierbei durch jeweils zwei in Umfangsrichtung der Lagerungsringe nebeneinander angeordnete Eingriffsteilelemente 53a, 53 b. Finger 54 des einen Eingriffsteilelements 53a sind jeweils um den Abstand zueinander versetzt, den die Eingriffstaschen 45 einer Reihe 46a oder 46b (Fig. 5) zueinander aufweisen. Gleiches gilt für die Finger 54 des anderen Eingriffsteilelements 53b. Da in Bezug auf die Stapelachse (Z-Richtung) die Finger 54 der beiden Eingriffsteilelemente 53a, 53b zudem um jeweils den halben Abstand von aufeinander folgenden Eingriffstaschen 45 versetzt sind, greift das Eingriffsteilelement 53a in jeweils aufeinander folgende Taschen 45 der einen Reihe 46a. Die Finger 54 des anderen Eingriffsteilelement 53b greift in daneben liegende, jedoch in Z-Richtung um den halben Taschenabstand versetzt liegende, Taschen 45 der anderen Reihe 46b (Fig. 5 und Fig. 10).

Mit dieser Vorrichtung lassen sich zwei unterschiedliche Zugriffsverfahren ausführen, durch die - in Bezug auf die Position im Stapel - entweder ein geradzahliger oder ein ungeradzahliger Lagerungsring für einen Zugriff freigestellt werden kann. Beim ersten Verfahren ist die Hülse 51 am oberen Eingriffsteil 53 mittels der Klinke arretiert. Bei beiden Verfahren wird für eine Freistellung zunächst die Bodenplatte 13 mit den Lagerungsringen auf eine bestimmte Z-Position entlang der Stapelachse verfahren, wodurch der untere Eingriffsteil 49 gegenüber einer bestimmten Eingriffstasche 45 angeordnet ist. Es handelt sich hierbei um eine Eingriffstasche 45', die nach unten von dem Lagerungsring 1' begrenzt wird, der freigestellt werden soll. Diese Situation ist in Fig. 11a wiedergegeben.

Nachfolgend wird nun das Öffnungsmittel auf den Stapel 3 zugeschwenkt, wodurch der Eingriffsfinger 50 des unteren Eingriffsteils 49 in die besagte Eingriffstasche 45' eingreift. Die Eingriffsfinger 54 des oberen Eingriffsteils 53 gelangen hierdurch in die fünf Eingriffstaschen 45 die sich in vertikaler Richtung unmittelbar über der besagten Eingriffstasche 45' befinden. Dies ist in Fig. 11b dargestellt. Danach wird die Kolbenstange 48 so weit eingefahren, bis der Anschlag 48a der Kolbenstange 48 auf die obere scheibenförmige Stirnseite 51a der Hülse 51 trifft. Simultan zu dieser Bewegung wird auch die Bodenplatte weiter 13 abgesenkt, wobei die von der Bodenplatte 13 zurückgelegte Strecke größer ist, als der vom unteren Eingriffselement 49 zurückgelegte Weg.

Wie in Fig. 11c dargestellt ist, wird durch diese Bewegungen der freizustellende Lagerungsring 1' als oberstes Lagerungselement eines nach unten abgesenkten Teils 3a des Stapels verfahren. Durch das Auftreffen des Anschlags 48a der Kolbenstange 48 an der oberen Stirnseite 51a m wird ein vorbestimmter Abstand zwischen dem freizustellenden Lagerungsring 1' und dem vom oberen Eingriffsteil gehaltenen oberen Stapelteils 3b geschaffen. Aufgrund des von der Bodenplatte 13 gegenüber dem unteren Eingriffsteil 49 zurückgelegten größeren Weges wird zudem auch ein Abstand vorbestimmter Größe zwischen dem freizustellenden Lagerungsring 1' und dem diesem nach unten nachfolgenden Lagerungsring 1" geschaffen. Hierdurch ist genügend Raum vorhanden, um mit einem üblichen Greifer unter den Wafer des freigestellten Lagerungsringes 1' zu fahren, den Wafer anzuheben und dann aus dem Stapel herauszunehmen. Durch eine Verfahrbewegung der Bodenplatte 13 nach oben kann der Stapel nach einem Zugriff auf den bestimmten Lagerungsring wieder geschlossen werden.

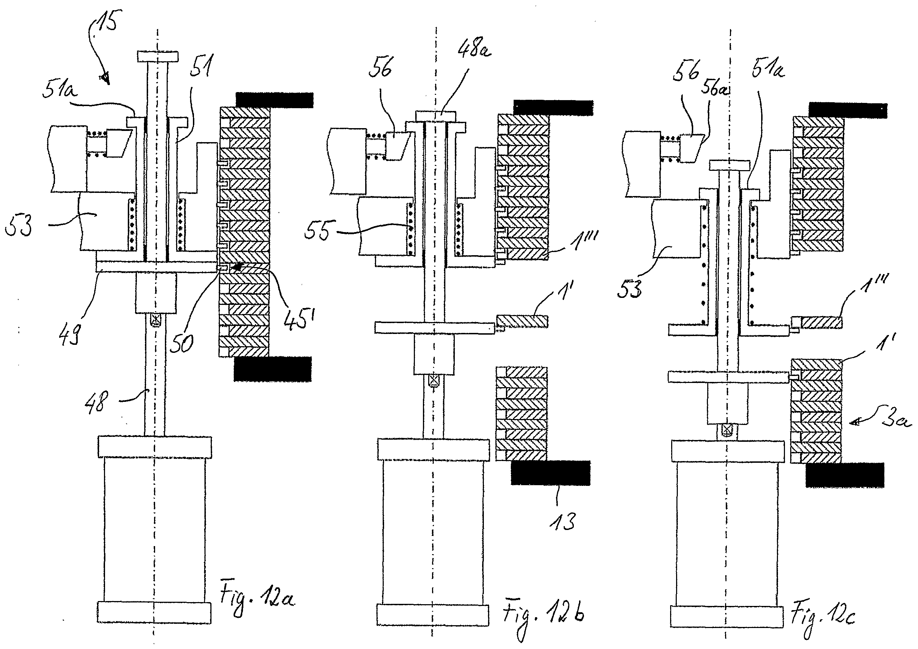

Beim zweiten, in den Fig. 12a-c gezeigten, Zugriffsverfahren soll ein Lagerungsring 1"' freigestellt werden, der von der Bodenplatte 13 ausgehend an einer ungeraden Stelle im Stapel 3 angeordnet ist, beispielsweise an der 11. Position. Auch hierzu wird der Stapel in eine bestimmte Position in Bezug auf das untere Eingriffselement 49 verfahren, nämlich der in Fig. 12a gezeigten Position. Dann werden gemäss der Darstellung von Fig. 12a, die Öffnungseinrichtungen 15 auf den Stapel zugeschwenkt. Hierbei ist die Hülse 51 noch durch die Klinke 56 verriegelt. Als Ergebnis dieser Bewegung befindet sich der Eingriffsfinger 50 des unteren Eingriffsteils 49 in der auf den freizustellenden Lagerungsring folgenden nächst unteren Eingriffstasche 45'.

Nun beginnt die Kolbenstange 48 mit der Einzugsbewegung und die Bodenplatte 13 wird abgesenkt, wie dies in Fig. 12b gezeigt ist. Zudem wird die Klinke 56 zurückgezogen, wodurch die Hülse 51 gegenüber dem oberen Eingriffselement 53 entsperrt wird. Bei der nachfolgenden weiteren Einzugsbewegung der Kolbenstange drückt die Druckfeder 55 die Hülse 51 nach unten, während das obere Eingriffselement 53 aufgrund seiner starren Verbindung zum Träger der Öffnungseinrichtung seine Position beibehält. Die Bewegung der Hülse 51 wird gestoppt, sobald die obere Stirnseite 51a der Hülse 51 am oberen Eingriffselement 53 anschlägt. Hierdurch wird der Lagerungsring 1"' gegenüber den über ihm befindlichen Lagerungsringen freigestellt, wie dies in Fig. 12c gezeigt ist.

Durch die Einzugsbewegung der Kolbenstange 48 und die gleichzeitige Verfahrbewegung der Bodenplatte 13 wird der unterhalb des freizustellenden Lagerungsrings befindliche Stapelteil 3a nach unten vom besagten Lagerungsring 1''' entfernt. Dies geschieht schon alleine aufgrund der Gewichtskraft der in diesem Stapelteil befindlichen Lagerungsringe.

Der freizustellende Lagerungsring 1'" wird von dem Eingriffsfinger 52 der Hülse 51 gehalten. Da der Betrag der Relativbewegung zwischen dem oberen Eingriffselement 53 und der Hülse 51 kleiner ist als der vom unteren Eingriffselement 49 bzw. der Bodenplatte 13 zurückgelegte Weg ist der besagte Lagerungsring 1'" auch gegenüber sämtlichen unter ihm im Stapel angeordneten Lagerungsringen für einen Zugriff freigestellt. Auch hier kann durch eine Bewegung der Bodenplatte nach oben der Stapel wieder geschlossen werden, wobei hierbei durch eine Schräge 56a der Klinke letztere von alleine in ihre Verriegelungsposition in der Hülse gelangt.

Bei sämtlichen Ausführungsformen der Erfindung könnten anstelle einer horizontalen Ausrichtung der Lagerungsringe und Wafer auch eine im wesentlichen vertikale Ausrichtung vorgesehen sein.

**Bezugszeichenliste**

| | | | |
|---|---|---|---|
| 1 | Lagerungsring | 29 | Lichtstrahl |
| 2 | Stapelbereich | 30 | Lichtempfänger |
| 3 | Stapel | 32 | Bereich |
| 4 | Ringteil | 33 | Dichtungsbereich |
| 5 | Zentrierelemente | 34 | Kanalbereich |
| 6 | Stapelachse | 35 | Ianglochartige Ausnehmung |
| 7 | Lagerbereich | 36 | Durchmesserlinie |
| 8 | Wafer | 37 | Stege |
| 9 | Halterungselement | 38 | Kanal |
| 9a | erster Abschnitt | 38a | Spalt |
| 9b | zweiter Abschnitt | 40 | Einkerbung |
| 10 | Auflagefläche | 41 | Abflachung |
| 11 | innere Umfangsfläche | 42 | Abschnitt |
| 12 | Deckplatte | 43 | Einkerbung |
| 12a | Ausnehmung | 45 | Eingriffstasche |
| 13a | Anschluss | 46a | Reihe |
| 13 | Bodenplatte | 46b | Reihe |
| 15 | Öffnungseinrichtung | 47 | Zylinder |
| 16 | Halteelement | 48 | Kolbenstange |
| 17 | Haltelement | 48a | Anschlag |
| 18 | Halteelement | 49 | unteres Eingriffsteil |
| 19 | Träger | 50 | Eingriffsfinger |
| 20 | Schwenkachse | 51 | Hülse |
| 21 | Nut | 51a | Stirnseite |
| 24 | Separierelement | 51b | Stirnseite |
| 25 | Separierelement | 52 | Eingriffsfinger |
| 26 | Nut | 53 | oberes Eingriffsteil |
| 27 | Schlitten | 53a | Eingriffsteilelement |
| 28 | Lichtsender | 53b | Eingriffsteilelement |
| 54 | Eingriffsfinger | | |
| 55 | Druckfeder | | |
| 56 | Klinke | | |
| 56a | Schräge | | |
| 57 | Druckfeder | | |
| 58 | Kolben | | |

## Patentansprüche

1. Vorrichtung zum Lagern von plattenförmigen Substraten, insbesondere von Wafern (8) oder Testwafern, wie sie vor allem in der Fertigung von elektronischen Bauteilen vorkommen, wobei die Vorrichtung
mehrere in einer Stapelrichtung aufeinander folgende und relativ zueinander bewegliche Lagerungselemente aufweist, die jeweils zur Aufnahme von zumindest einem Substrat vorgesehen sind, die Lagerungselemente jeweils mit Mitteln zur Auflage der Substrate versehen sind,
die Lagerungselemente einen Stapelbereich (2) aufweisen, der zur Anordnung des jeweiligen Lagerungselements innerhalb eines Stapels (3) von Lagerungselementen vorgesehen ist, und zumindest einige der Lagerungselemente im Wesentlichen gleich ausgebildet sind, **dadurch gekennzeichnet, dass** zur Kompensation von Stapelfehlern die Lagerungselemente in Bezug auf ihre Umfangsrichtung zueinander rotationsversetzt angeordnet sind,
dass aufeinander angeordnete Lagerungselemente Einkerbungen (40) und Abflachungen (41) für ein Öffnungsmittel ausbilden, derart dass aufeinander gestapelte Lagerungselemente zumindest zwei im Wesentlichen nebeneinander angeordnete Reihen (46a, 46b) von Einkerbungen (40) und Abflachungen (41) ausbilden, und dass die Einkerbungen (40) und Abflachungen (41) der beiden Reihen (46a, 46b) in Richtung einer Stapelachse (6) um den halben Abstand versetzt sind, den in einer der Reihen (46a, 46b) aufeinander folgende Einkerbungen (40) und Abflachungen (41) aufweisen.

2. Vorrichtung nach Anspruch 1, **dadurch gekennzeichnet, dass** von drei oder mehr im Stapel (3) hintereinander angeordneten Lagerungselementen aufeinander folgende Lagerungselemente in Bezug auf die Stapelachse (6) zueinander rotationsversetzt angeordnet sind, wobei sich das erste und das letzte dieser aufeinander folgenden drei oder mehr Lagerungselemente zumindest im Wesentlichen in der gleichen Rotationsposition befinden.

3. Vorrichtung nach Anspruch 1 oder 2, **dadurch gekennzeichnet, dass** mehrere aufeinander folgende Lagerungselemente um den gleichen Winkelbetrag zueinander rotationsversetzt sind.

4. Vorrichtung nach Anspruch 3, **dadurch gekennzeichnet, dass** drei oder mehr aufeinander folgende Lagerungselemente um jeweils den gleichen Winkelbetrag zueinander versetzt sind.

5. Vorrichtung nach Anspruch 1, **dadurch gekennzeichnet, dass** aufeinander folgende Lagerungselemente jeweils um einen Winkelbetrag von 180° zueinander rotationsversetzt sind.

6. Vorrichtung nach zumindest einem der vorhergehenden Ansprüche, **gekennzeichnet durch** zumindest ein Öffnungsmittel, mit dem ein Abstand zwischen zwei im Stapel (3) von Lagerungselementen angeordneten Lagerungselemente veränderbar, insbesondere vergrößerbar, ist, sowie durch zumindest ein Detektionsmittel, mit dem Informationen über Positionen von einzelnen Lagerungselementen im Stapel (3) ermittelbar sind, und eine Steuerung, der die Positionsinformationen zuführbar sind, und mit der unter Berücksichtigung der Positionsinformationen Steuerungssignale erzeugbar sind, mit denen das Öffnungsmittel und der Stapel (3) relativ zueinander verfahrbar und relativ zueinander in einer Sollposition positionierbar sind.

7. Vorrichtung nach Anspruch 6, **dadurch gekennzeichnet, dass** die Positionsinformationen zur Erzeugung einer Verfahrbewegung des Stapels (3) in Stapelrichtung vorgesehen sind.

8. Vorrichtung nach Anspruch 6 oder 7, **dadurch gekennzeichnet, dass** die Positionsinformationen zur Erzeugung einer Verfahrbewegung des Öffnungsmittels vorgesehen sind.

9. Vorrichtung nach einem der Ansprüche 6 bis 8, **dadurch gekennzeichnet, dass** das Öffnungsmittel mit zumindest zwei in Umfangsrichtung des Stapels (3) zueinander versetzten Öffnungseinrichtungen (15) versehen ist, die zum im Wesentlichen zeitgleichen Kontakt mit einem der Lagerungselemente vorgesehen sind, wobei die zumindest zwei Öffnungseinrichtungen (15) in Stapelrichtung unabhängig voneinander verfahrbar sind.

10. Vorrichtung nach Anspruch 9, **dadurch gekennzeichnet, dass** die zumindest zwei Öffnungseinrichtungen (15) sowohl gemeinsam als auch unabhängig voneinander verfahrbar sind.

11. Vorrichtung nach den Ansprüchen 6 und 9, **gekennzeichnet durch** zumindest zwei Detektionsmittel, von denen jedes Detektionsmittel einem anderen der zumindest zwei Öffnungseinrichtungen (15) zugeordnet ist, und die zumindest zwei Detektionsmittel zur Bestimmung von Positionsinformationen von Lagerungselementen vorgesehen sind, wobei Positionsinformationen der Detektionsmittel zur Erzeugung von relativen Verfahrbewegungen zwischen den Öffnungseinrichtungen (15) vorgesehen sind.

12. Vorrichtung nach zumindest einem der vorhergehenden Ansprüche, **dadurch gekennzeichnet, dass** der Stapel (3) von Lagerungselementen von jeweils zwei aufeinander angeordneten Lagerungselementen gemeinsam ausgebildete Eingriffstaschen (45) aufweist, die durch die Einkerbungen (40) und Abflachungen (41) der beiden Reihen (46a, 46b) ausgebildet sind.

13. Vorrichtung nach zumindest einem der vorhergehenden Ansprüche, **gekennzeichnet durch** Mittel zur Einleitung eines Mediums in den Stapel (3) sowie durch im Stapel (3) angeordnete Gasleitmittel.

14. Vorrichtung nach Anspruch 13, **gekennzeichnet durch** zumindest ein Gasleitelement, durch welches das Medium in einen Bereich leitbar ist, der zur Auflage von Substraten vorgesehen ist.

15. Vorrichtung nach Anspruch 13 oder 14, **dadurch gekennzeichnet, dass** an Lagerungselementen Gasleitmittel angeordnet sind, insbesondere an Lagerungselementen ausgebildet sind.

16. Vorrichtung nach einem der Ansprüche 13 bis 15, **gekennzeichnet durch** einen im Stapel (3) angeordneten Kanal (38), insbesondere einen zumindest im Wesentlichen über die gesamte Höhe des Stapels (3) verlaufenden Kanal (38), der vorzugsweise zumindest im Wesentlichen parallel zur Stapelachse (6) ausgerichtet ist.

17. Vorrichtung nach einem der Ansprüche 13 bis 16, **gekennzeichnet durch** zumindest ein von Lagerungselementen ausgebildetes Gasleitelement der Gasleitmittel, sowie durch Dichtungen, von denen zumindest jeweils eine zwischen jeweils zwei im Stapel (3) aufeinander folgenden Lagerungselementen vorgesehen ist, wobei ein Abstand des zumindest einen Gasleitelements zur Stapelachse (6) geringer ist als ein Abstand von zumindest einer der Dichtungen zur Stapelachse (6).

18. Vorrichtung nach Anspruch 17, **dadurch gekennzeichnet, dass** die Dichtungen von den Lagerungselementen selbst ausgebildet werden.

19. Vorrichtung nach Anspruch 18, **dadurch gekennzeichnet, dass** zumindest eine der Dichtungen jeweils Stege (37) von aufeinander folgenden Lagerungselemente umfasst.

20. Vorrichtung nach zumindest einem der vorhergehenden Ansprüche 16 bis19, **gekennzeichnet durch** jeweils zumindest eine an den Lagerungselementen vorgesehene Stapelhilfe, wobei ein Abstand der zumindest einen Stapelhilfe eines Lagerungselements zur Stapelachse (6) grösser ist als der Abstand zur Stapelachse (6), den eine zum jeweils gleichen Lagerungselement gehörende Dichtung aufweist.

21. Vorrichtung nach zumindest einem der vorhergehenden Ansprüchen, **dadurch gekennzeichnet, dass** zumindest ein Gasleitmittel als Kanal (38) ausgebildet ist, der sich durch Ausnehmungen von aufeinander gestapelten Lagerungselementen ergibt.

22. Verfahren zum Lagern von plattenförmigen Substraten, insbesondere von Wafern (8) oder Testwafern, wie sie vor allem in der Fertigung von elektronischen Bauteilen vorgesehen sind, bei denen vereinzelbare Lagerungselemente einer Vorrichtung nach einem der vorhergehenden Ansprüche in einer Stapelrichtung hintereinander zu einem Stapel (3) angeordnet werden, auf Auflagemitteln der Lagerungselemente jeweils ein Substrat angeordnet werden kann, und ein Abstand von Lagerungselementen zueinander mittels einem Öffnungsmittel veränderbar ist, **dadurch gekennzeichnet, dass** mit einem Detektionsmittel Informationen über Positionen von einzelnen Lagerungselementen im Stapel (3) ermittelt werden, die Positionsinformationen einer Steuerung zugeführt werden, und eine Relativbewegung zwischen dem Stapel (3) und dem Öffnungsmittel in Abhängigkeit der Positionsinformationen erzeugt wird, durch die das Öffnungsmittel in einer vorbestimmten relativen Sollposition gegenüber einem der Lagerungselemente positionierbar ist.

23. Verfahren nach Anspruch 22, **dadurch gekennzeichnet, dass** mit mindestens zwei Detektionsmitteln unabhängig voneinander Positionsinformationen von Lagerungselementen ermittelt werden, und diese Positionsinformationen der Steuerung zugeführt werden, die unter Berücksichtigung der Positionsinformationen Verfahrbewegungen veranlasst, durch die zumindest zwei Öffnungseinrichtungen (15) des Öffnungsmittels für die Erzeugung eines Abstandes von einem bestimmten Lagerungselement zum im Stapel (3) benachbarten Lagerungselement in Bezug auf die Stapelachse (6) unabhängig voneinander positioniert werden.

## Claims

1. Device for storing planar substrates, in particular wafers (8) or test wafers such as those which are primarily found in the manufacture of electronic components, the device having a plurality of storage elements which are consecutive in a stacking direction, movable in relation to one another and are each provided to receive at least one substrate, the storage elements each being provided with means for supporting the substrates, the storage elements having a stacking region (2) which is provided for arranging the relevant storage element within a stack (3) of storage elements, and at least some of the storage elements being substantially the same, **characterised in that**, in order to compensate for stacking errors, the storage elements are arranged such that they are rotationally offset from one another with respect to their circumferential direction, **in that** storage elements arranged one on top of the other form notches (40) and flattened portions (41) for an opening means such that storage elements stacked one on top of the other form at least two substantially juxtaposed rows (46a, 46b) of notches (40) and flattened portions (41), and **in that** the notches (40) and flattened portions (41) of the two rows (46a, 46b) are offset in the direction of a stacking axis (6) by half the distance between consecutive notches (40) and flattened portions (41) in one of the rows (46a, 46b).

2. Device according to claim 1, **characterised in that** consecutive storage elements of three or more storage elements arranged one behind the other in the stack (3) are arranged such that they are rotationally offset from one another in relation to the stacking axis (6), the first and the last of these three or more consecutive storage elements being at least substantially in the same rotational position.

3. Device according to either claim 1 or claim 2, **characterised in that** a plurality of consecutive storage elements are rotationally offset from one another by the same angular amount.

4. Device according to claim 3, **characterised in that** three or more consecutive storage elements are offset from one another by the same angular amount in each case.

5. Device according to claim 1, **characterised in that** consecutive storage elements are each rotationally offset from one another by an angular amount of 180°.

6. Device according to at least one of the preceding claims, **characterised by** at least one opening means by means of which a distance between two storage elements arranged in the stack (3) of storage elements can be changed, in particular enlarged, and by at least one detection means by means of which information about positions of individual storage elements in the stack (3) can be determined, and a control system to which the position information can be supplied, and by means of which, taking into account the position information, control signals can be generated by means of which the opening means and the stack (3) are movable relative to one another and can be positioned relative to one another in a desired position.

7. Device according to claim 6, **characterised in that** the position information is provided for generating a movement of the stack (3) in the stacking direction.

8. Device according to either claim 6 or claim 7, **characterised in that** the position information is provided for generating a movement of the opening means.

9. Device according to any of claims 6 to 8, **characterised in that** the opening means is provided with at least two opening apparatuses (15) that are offset from one another in the circumferential direction of the stack (3) and are provided for substantially simultaneous contact with one of the storage elements, the at least two opening apparatuses (15) being movable independently of one another in the stacking direction.

10. Device according to claim 9, **characterised in that** the at least two opening apparatuses (15) can be moved both together and independently of one another.

11. Device according to claims 6 and 9, **characterised by** at least two detection means, each of which detection means is assigned to another of the at least two opening apparatuses (15), and the at least two detection means are provided for determining position information of storage elements, position information of the detection means being provided for generating relative movements between the opening apparatuses (15).

12. Device according to at least one of the preceding claims, **characterised in that** the stack (3) of storage elements has pockets (45) which are jointly formed by two storage elements arranged one on top of the other in each case and are formed by the notches (40) and flattened portions (41) of the two rows (46a, 46b).

13. Device according to at least one of the preceding claims, **characterised by** means for introducing a medium into the stack (3) and by gas conducting means arranged in the stack (3).

14. Device according to claim 13, **characterised by** at least one gas conducting element by means of which the medium can be conducted into a region which is provided to support substrates.

15. Device according to either claim 13 or claim 14, **characterised in that** gas conducting means are arranged on storage elements, in particular formed on storage elements.

16. Device according to any of claims 13 to 15, **characterised by** a channel (38) arranged in the stack (3), in particular a channel (38) that extends at least substantially over the entire height of the stack (3) and is preferably aligned at least substantially parallel to the stacking axis (6).

17. Device according to any of claims 13 to 16, **characterised by** at least one gas conducting element of the gas conducting means that is formed by storage elements, and also by seals, at least one of which is provided between each two consecutive storage elements in the stack (3) in each case, a distance between the at least one gas conducting element and the stacking axis (6) being less than a distance between at least one of the seals and the stacking axis (6).

18. Device according to claim 17, **characterised in that** the seals are formed by the storage elements themselves.

19. Device according to claim 18, **characterised in that** at least one of the seals comprises connecting pieces (37) of consecutive storage elements in each case.

20. Device according to at least one of the preceding claims 16 to 19, **characterised by** at least one stacking aid provided on the storage elements in each case, a distance between the at least one stacking aid of a storage element and the stacking axis (6) being greater than the distance between the stacking axis (6) and the seal belonging to a storage element that is the same in each case.

21. Device according to at least one of the preceding claims, **characterised in that** at least one gas conducting means is formed as a channel (38) which results from recesses of storage elements stacked one on top of the other.

22. Method for storing planar substrates, in particular wafers (8) or test wafers such as those which are primarily provided in the manufacture of electronic components, in which method separable storage elements of a device according to any of the preceding claims are arranged one behind the other in a stacking direction to form a stack (3), a substrate can be arranged on support means of the storage elements in each case, and a distance of storage elements to one another can be changed by means of an opening means, **characterised in that** information about positions of individual storage elements in the stack (3) is determined using a detection means, the position information is fed to a control system, and a relative movement between the stack (3) and the opening means is generated on the basis of the position information, by means of which relative movement the opening means can be positioned in a predetermined relative desired position in relation to one of the storage elements.

23. Method according to claim 22, **characterised in that** position information of storage elements is determined independently of one another using at least two detection means, and this position information is supplied to the control system which, taking into account the position information, cause movements by means of which at least two opening apparatuses (15) of the opening means are positioned independently of one another in relation to the stacking axis (6) in order to generate a distance between a particular storage element and the adjacent storage element in the stack (3).

## Revendications

1. Dispositif pour stocker des substrats en forme de disque, en particulier des wafers (8) ou des wafers de test, comme ils sont surtout utilisés dans la fabrication de composants électroniques, le dispositif comprenant
plusieurs éléments de stockage successifs dans un sens d'empilement et mobiles l'un par rapport à l'autre, qui sont respectivement prévus pour recevoir au moins un substrat, où les éléments de stockage sont respectivement dotés de moyens pour le support des substrats,
où les éléments de stockage comprennent une région d'empilement (2) prévue pour l'arrangement de l'élément de stockage respectif dans un empilement (3) d'éléments de stockage, et
où au moins quelques-uns des éléments de stockage sont adaptés essentiellement de la même manière,
**caractérisé en ce que**
pour la compensation d'erreurs d'empilement les éléments de stockage sont arrangés les uns par rapport aux autres avec un décalage de rotation par rapport à leur sens circonférentiel,
**en ce que** des éléments de stockage disposés les uns sur les autres forment des encoches (40) et des aplatissements (41) pour un moyen d'ouverture, de sorte que des éléments de stockage disposés les uns empilés sur les autres forment au moins deux rangées (46a, 46b) d'encoches (40) et d'aplatissements (41) disposées l'une à côté de l'autre, et **en ce que** les encoches (40) et les aplatissements (41) des deux rangées (46a, 46b) sont décalés dans le sens d'un axe d'empilement (6) par la moitié de la distance des encoches (40) et des aplatissements (41) successifs dans une des rangées (46a, 46b).

2. Dispositif selon la revendication 1, **caractérisé en ce que** parmi trois ou plusieurs éléments de stockage arrangés l'un derrière l'autre dans l'empilement (3) des éléments de stockage successifs sont décalés l'un par rapport à l'autre en rotation par rapport à l'axe d'empilement (6), le premier et le dernier de ces trois ou plusieurs éléments de stockage successifs étant au moins essentiellement dans la même position de rotation.

3. Dispositif selon la revendication 1 ou 2, **caractérisé en ce que** plusieurs éléments de stockage successifs sont décalés en rotation l'un par rapport à l'autre par la même valeur d'angle.

4. Dispositif selon la revendication 3, **caractérisé en ce que** trois ou plusieurs éléments de stockage successifs sont chacun décalés l'un par rapport à l'autre par la même valeur d'angle.

5. Dispositif selon la revendication 1, **caractérisé en ce que** des éléments de stockage successifs sont décalés en rotation l'un par rapport à l'autre par une valeur d'angle de 180°.

6. Dispositif selon au moins une des revendications précédentes, **caractérisé par** au moins un moyen d'ouverture par lequel une distance entre deux éléments de stockage arrangés dans l'empilement (3) d'éléments de stockage est modifiable, et peut en particulier être agrandie, ainsi que par au moins un moyen de détection, grâce auquel des informations sur des positions d'éléments de stockage individuels dans l'empilement (3) sont détectables, et
une commande, à laquelle les informations de position peuvent être fournies, et par laquelle des signaux de commande peuvent être générés en prenant en compte les informations de position, par lesquels le moyen d'ouverture et l'empilement (3) sont déplaçables l'un par rapport à l'autre et peuvent être positionnés dans une position désirée l'un par rapport à l'autre.

7. Dispositif selon la revendication 6, **caractérisé en ce que** les informations de position sont prévues pour générer un mouvement de déplacement de l'empilement (3) dans la direction d'empilement.

8. Dispositif selon la revendication 6 ou 7, **caractérisé en ce que** les informations de position sont prévues pour générer un mouvement de déplacement du moyen d'ouverture.

9. Dispositif selon une des revendications 6 à 8, **caractérisé en ce que** le moyen d'ouverture est doté d'au moins deux dispositifs d'ouverture (15) décalés l'un par rapport à l'autre dans la direction circonférentiel de l'empilement (3), prévus pour le contact essentiellement simultané avec un des éléments de stockage, où lesdits au moins deux dispositifs d'ouverture (15) peuvent être déplacés indépendamment dans la direction d'empilement.

10. Dispositif selon la revendication 9, **caractérisé en ce que** les au moins deux dispositifs d'ouverture (15) peuvent être déplacés en même temps et aussi indépendamment.

11. Dispositif selon les revendications 6 et 9, **caractérisé par** au moins deux moyens de détection dont chaque moyen de détection est associé à un autre des au moins deux dispositifs d'ouverture (15), et où les au moins deux moyens de détection sont prévus pour la détermination d'informations de position d'éléments de stockage, où des informations de position des moyens de détection sont prévus pour générer des mouvements de déplacement relatifs entre les dispositifs d'ouverture (15).

12. Dispositif selon au moins une des revendications précédentes, **caractérisé en ce que** l'empilement (3) d'éléments de stockage comprend des poches d'engagement (45) formées par l'ensemble de respectivement deux éléments de stockage successifs, formées par les encoches (40) et les aplatissements (41) des deux rangées (46a, 46b).

13. Dispositif selon au moins une des revendications précédentes, **caractérisé par** des moyens pour l'introduction d'un médium dans l'empilement (3) ainsi que par des moyens de transport de gaz arrangés dans l'empilement (3).

14. Dispositif selon la revendication 13, **caractérisé par** au moins un élément de transport de gaz, par lequel le médium peut être transporté dans une région prévue pour le support de substrats.

15. Dispositif selon les revendications 13 ou 14, **caractérisé en ce que** des moyens de transport de gaz sont prévus à des éléments de stockage et sont en particulier formés à des éléments de stockage.

16. Dispositif selon une des revendications 13 à 15, **caractérisé par** un canal (38) arrangé dans l'empilement (3), en particulier un canal (38) s'étendant au moins essentiellement sur la hauteur entière de l'empilement (3), qui est de préférence orienté au moins essentiellement parallèlement à l'axe d'empilement (6).

17. Dispositif selon une des revendications 13 à 16, **caractérisé par** au moins un élément de transport de gaz des moyens de transport de gaz formé par des éléments de stockage ainsi que par des joints, dont au moins un est respectivement prévu entre deux éléments de stockage successifs dans l'empilement (3), où une distance dudit au moins un élément de transport de gaz de l'axe d'empilement (6) est inférieure à une distance d'au moins un des joints avec l'axe d'empilement (6).

18. Dispositif selon la revendication 17, **caractérisé en ce que** les joints sont formés par les éléments de stockage eux-mêmes.

19. Dispositif selon la revendication 18, **caractérisé en ce qu'**au moins un des joints comprend respectivement des pontages (37) d'éléments de stockage successifs.

20. Dispositif selon au moins une des revendications précédentes 16 à 19, **caractérisé par** respectivement au moins un aide d'empilement prévu aux éléments de stockage, où une distance de ladite au moins une aide d'empilement d'un élément de stockage avec l'axe d'empilement (6) est plus grande que la distance de l'axe d'empilement (6) d'un joint associé avec le même élément de stockage.

21. Dispositif selon au moins une des revendications précédentes, **caractérisé en ce qu'**au moins un moyen de transport de gaz est adapté sous forme d'un canal (38) résultant d'encoches d'éléments de stockage empilés l'un sur l'autre.

22. Procédé pour stocker des substrats en forme de disque, en particulier des wafers (8) ou des wafers de test, comme ils sont surtout utilisés dans la fabrication de composants électroniques, où des éléments de stockage séparables d'un dispositif selon une des revendications précédentes sont arrangés en un empilement (3) de manière successive dans une direction d'empilement, où un substrat peut respectivement être arrangé sur des moyens de support des éléments de stockage, et où une distance des éléments de stockage l'un de l'autre peut être modifiée par un moyen d'ouverture,
**caractérisé en ce que** grâce à un moyen de détection des informations sur des positions d'éléments de stockage individuels dans l'empilement (3) sont détectés, que les informations de position sont fournies a une commande, qu'un mouvement relatif entre l'empilement (3) et le moyen d'ouverture est généré en fonction des informations de position par lesquelles le moyen d'ouverture peut être positionné dans une position relative désirée et prédéterminée par rapport à un des éléments de stockage.

23. Procédé selon la revendication 22, **caractérisé en ce qu'**avec au moins deux moyens de détection des informations de position sont déterminées séparément, et **en ce que** ces informations de position sont fournies à la commande qui, en prenant en compte les informations de position incitent des mouvements de déplacement par lesquels au moins deux dispositifs d'ouverture (15) du moyen d'ouverture sont positionnés indépendamment l'un de l'autre par rapport à l'axe d'empilement (6) pour générer une distance d'un certain élément de stockage à l'élément de stockage adjacent dans l'empilement (3).
